# FASCICULE DE BREVET EUROPEEN

(11) **EP 1 308 972 B1**
(45) Date de publication et mention de la délivrance du brevet: **05.03.2008**
(21) Numéro de dépôt: 02292538.2
(22) Date de dépôt: 15.10.2002
(51) Int. Cl.: H01G 5/00, H01G 5/16

(54) **Dispositif à capacité électrique variable intégrée et procédé de réalisation d'un tel dispositif**
Bauelement mit variabler Kapazität und Verfahren zur Herstellung
Variable capacity device and method of manufacturing

(30) Priorité: 17.10.2001 FR 0113371
(43) Date de publication de la demande: 07.05.2003
(73) Titulaire: COMMISSARIAT A L'ENERGIE ATOMIQUE, 75015 Paris (FR)
(72) Inventeur: Delapierre, Gilles, 38180 Seyssins (FR)
(74) Mandataire: Simonnet, Christine

(56) Documents cités:
- DE-A- 10 002 363
- US-A- 6 034 414
- US-A- 6 110 791
- HARSH K F ET AL: "The realization and design considerations of a flip-chip integrated MEMS tunable capacitor" SENSORS AND ACTUATORS A, ELSEVIER SEQUOIA S.A., LAUSANNE, CH, vol. 80, no. 2, mars 2000 (2000-03), pages 108-118, XP004192096 ISSN: 0924-4247

## Description

### Domaine technique

La présente invention concerne un dispositif à capacité électrique variable intégrée et un procédé de réalisation collective de tels dispositifs.

On entend par dispositif à capacité électrique variable, un dispositif ou un composant quelconque qui comprend un ou plusieurs condensateurs intégrés dont la capacité électrique peut être modifiée.

De tels dispositifs sont utilisés par exemple pour la réalisation de filtres résonnants que l'on souhaite pouvoir accorder sur différentes fréquences.

Une application particulière des dispositifs à capacité variable est la réalisation d'équipements de télécommunications par voie hertzienne. Le caractère intégré des capacités variables, est dicté par les impératifs de miniaturisation des équipements concernés.

### État de la technique antérieure

Une description de l'état de la technique est donnée par le document (1) dont les références sont précisées à la fin de la description. Des éléments complémentaires peuvent être trouvés dans les documents (2) à (4) dont les références sont également précisées en fin de description.

Une capacité électrique intégrée comprend généralement une armature fixe et une armature mobile, disposées en regard l'une de l'autre, et mutuellement isolées. L'armature mobile peut être formée ou supportée par une membrane. La mobilité de l'armature peut résulter du caractère flexible et déformable de la membrane, ou du fait que cette dernière soit reliée à un support fixe par l'intermédiaire de moyens flexibles, tels que des poutrelles.

L'espace séparant les armatures peut être vide ou peut contenir un gaz. La capacité variable est généralement associée à des moyens moteurs de commande. Ceux-ci permettent de déplacer l'armature mobile par rapport à l'armature fixe. Le déplacement de l'armature mobile a pour effet de modifier la distance séparant les armatures en regard et ainsi de modifier la capacité du condensateur formé par les armatures.

On connaît pour l'essentiel trois types de moyens moteurs utilisables pour la commande de déplacement de l'armature mobile. On distingue en effet les moyens électrostatiques, les moyens piézoélectriques et les moyens thermiques à dilatation différentielle (bilame).

Parmi ces moyens, on privilégie généralement la commande électrostatique. La préférence va à ce type de commande pour la simplicité de sa réalisation et pour sa consommation électrique réduite. Les moyens moteurs électrostatiques utilisent des électrodes entre lesquelles on génère des forces électrostatiques par application d'une différence de potentiel. Les forces sont mises à profit pour le déplacement de l'armature mobile.

Avec des dispositifs fortement miniaturisés, une difficulté importante apparaît toutefois pour la fourniture de la tension de commande nécessaire à l'exercice des forces électrostatiques. Celle-ci est de l'ordre de 10 à 100 volts.

Une solution possible pour limiter la tension de commande consiste à assouplir les poutrelles de maintien de l'armature mobile. Une meilleure flexibilité des poutres autorise, en effet, une tension de commande plus faible.

En revanche, elle accroît également la sensibilité du dispositif à des accélérations. On peut se référer à ce sujet aux documents (2) et (3) qui proposent de mettre à profit la sensibilité d'une armature mobile à l'accélération pour la réalisation d'un accéléromètre.

Dans les dispositifs visés par le présent exposé, toutefois, les accélérations, y compris celle de la pesanteur, ont pour effet de déplacer l'armature mobile et de générer des variations incontrôlées de la capacité. Ce phénomène est particulièrement gênant dans des équipements portables, sujets à des accélérations fortes et répétées.

Une réduction de l'effet indésirable est possible en utilisant des armatures mobiles sous la forme de membranes très fines, ou portées par de telles membranes. Leur faible poids les rend, en effet, moins sensibles à l'accélération.

L'utilisation de membranes fines présente cependant d'autres difficultés. Par exemple, des modes de résonance propres des membranes, à basse fréquence, peuvent générer des instabilités de la capacité. Par ailleurs les membranes très fines sont fragiles et sujettes à des déformations au cours du temps. Il en résulte notamment une dérive de la capacité au repos, c'est-à-dire de la capacité en l'absence de champ électrique appliqué.

Le document US 6,110,791 montre un condensateur avec une membrane munie d'une nervure, la membrane étant diélectrique.

Le document US 6,034,414 montre un condensateur variable avec une membrane formant armature mobile mais sans nervure.

### Exposé de l'invention

La présente invention a pour but de proposer un dispositif à capacité variable intégrée ne présentant pas les limitations et difficultés ci-dessus.

Un but est en particulier de proposer un tel dispositif qui soit peu sensible aux accélérations et qui présente toutefois une bonne stabilité dans le temps, tout en présentant une faible consommation électrique et tout en étant susceptible d'être commandé par une tension faible.

Un but est encore de proposer un dispositif fiable susceptible d'être utilisé dans des équipements de télécommunication portables.

L'invention a aussi pour but de proposer un procédé de réalisation d'un tel dispositif.

Enfin, l'invention a pour but de proposer un procédé adapté à la fabrication collective et concomitante d'un grand nombre de dispositifs à capacité variable.

Pour atteindre ces buts l'invention concerne plus précisément un dispositif à capacité variable intégrée comprenant au moins une membrane formant au moins une armature mobile et présentant au moins une face principale en regard d'au moins une armature fixe. Conformément à l'invention, la membrane est solidaire d'au moins une nervure de rigidité se dressant dans une direction perpendiculaire à ladite face principale. De préférence, la nervure est la plus fine possible dans une direction parallèle à la face principale.

On considère que la membrane forme une armature mobile lorsqu'au moins une partie de la membrane, susceptible d'être rapprochée ou écartée de l'armature fixe est en un matériau conducteur, ou lorsque la membrane est pourvue en cette partie d'une couche de matériau conducteur formant une ou plusieurs armatures. En d'autres termes, au moins une partie de la membrane constitue ou porte une armature.

On considère que la membrane est en un matériau conducteur lorsque ce matériau conduit suffisamment l'électricité pour constituer une armature de condensateur. Ceci n'exclut donc pas le choix de matériaux semi-conducteurs.

Le déplacement de l'armature mobile peut avoir lieu en déformant la membrane, qui présente alors au moins une partie flexible, et/ou en déformant une ou plusieurs poutrelles de suspension de la membrane.

La nervure permet de conférer à la membrane, et donc à l'armature mobile, une bonne rigidité en dépit de sa minceur et donc de sa légèreté. Elle permet ainsi d'utiliser des membranes plus fines que dans les dispositifs connus. La membrane, ainsi rigidifiée, présente une meilleure tenue dans le temps, une meilleure stabilité, tout en restant relativement insensible aux accélérations.

La nervure est située sur au moins l'une des faces principales, c'est-à-dire l'une des faces de plus grande surface. Cette caractéristique permet d'optimiser la fonction de raidisseur de la ou des nervures, mais ne préjuge ni de la forme ni de l'orientation de la membrane.

Selon un aspect particulier de l'invention, le dispositif peut comporter un substrat portant la membrane et formant une ou plusieurs armatures fixes.

Ici encore, on considère que le substrat forme une armature fixe lorsqu'au moins une partie du substrat est en un matériau conducteur susceptible de constituer une armature, ou lorsque le substrat est pourvu d'une ou de plusieurs couches conductrices constituant des électrodes et formant ainsi la ou les armatures fixes.

Dans une réalisation particulière, le dispositif de l'invention peut comporter une première partie disposée en regard d'une première face principale de la membrane et une deuxième partie, solidaire de la première partie, et disposée en regard d'une deuxième face principale de la membrane, au moins l'une des première et deuxième parties formant une armature fixe.

Dans le cas ou la membrane est une membrane plane, le substrat peut comporter deux armatures fixes, disposées de part et d'autre de la membrane, en regard de ses deux faces principales. Avantageusement, l'une des armatures fixes peut être utilisée conjointement avec l'armature mobile pour former un moyen moteur de commande électrostatique pour le déplacement de la membrane. La deuxième armature fixe peut alors être réservée exclusivement à la constitution d'une capacité variable, avec l'armature mobile.

Il convient de préciser qu'un même jeu d'armatures fixe et mobile peut aussi être utilisé à la fois comme capacité variable et comme moteur électrostatique de commande.

L'invention concerne également un procédé de fabrication d'un dispositif à capacité variable dans lequel:
a) on fournit un substrat présentant au moins une première couche d'armature mince reliée à une partie massive par une couche enterrée isolante,
b) on forme sur la première couche d'armature mince, une couche d'arrêt de gravure, la couche d'arrêt de gravure présentant au moins une ouverture d'accrochage débouchant sur une partie de la couche d'armature mince destinée à former une armature mobile,
c) on forme au moins une couche de rigidité recouvrant la couche d'arrêt de gravure, et venant en contact avec la première couche d'armature mince dans l'ouverture d'accrochage,
d) on pratique une gravure sélective de la couche de rigidité pour y définir au moins une nervure de rigidité s'étendant au-dessus de l'ouverture d'accrochage, et sur la partie de la couche d'armature mince destinée à former une armature mobile,
e) on libère ladite partie par élimination locale de la couche d'arrêt de gravure et de la couche enterrée isolante, pour former l'armature mobile.

On entend par couche d'armature, une couche en un matériau conducteur, semi-conducteur ou résistif, susceptible de constituer une ou plusieurs armatures de condensateur.

Dans une mise en oeuvre particulière du procédé, on peut utiliser une couche d'arrêt de gravure en un matériau isolant électrique, et une couche de rigidité en un matériau électriquement conducteur. On préserve alors, lors de l'étape d), une partie de la couche de rigidité s'étendant au-dessus de la partie de la couche d'armature mince destinée à former une armature mobile, et on libère mutuellement lesdites parties de la couche de rigidité et de la couche d'armature mince.

La libération de la couche d'armature de la couche de rigidité permet de former la membrane. Elle peut avoir lieu par exemple par élimination locale d'une couche sacrificielle intercalaire. Cet aspect est encore décrit de façon plus détaillée dans la suite du texte.

Le substrat, ou plus précisément la partie massive du substrat, peut être utilisée éventuellement comme armature fixe, lorsqu'elle n'est pas isolante.

A titre d'alternative on peut aussi fournir, lors de l'étape a), un substrat présentant en outre, sous la première couche d'armature, une deuxième couche d'armature enterrée, électriquement isolée de la première couche d'armature. Dans ce cas, on peut préserver au moins une partie de cette couche en regard de l'armature mobile, pour former une armature fixe.

Selon encore une autre possibilité, on peut former dans la partie massive du substrat une zone conductrice formant armature fixe par implantation ionique.

L'élimination sélective d'une partie sacrificielle de la couche enterrée peut avoir lieu en pratiquant une ou de préférence plusieurs ouvertures d'accès à cette couche pour la soumettre à des agents de gravure. Cette opération peut être grandement facilitée, lorsqu'on prévoit avant même l'étape b) une ou plusieurs ouvertures de gravure dans la première couche d'armature.

D'autres caractéristiques et avantages de l'invention ressortiront de la description qui va suivre, en référence aux figures des dessins annexés. Cette description est donnée à titre purement illustratif et non limitatif.

### Brève description des figures

La figure 1 est une coupe schématique et simplifiée d'un dispositif à capacité variable conforme à l'invention.

La figure 2 est une vue de dessus, également simplifiée d'un autre dispositif à capacité variable conforme à l'invention.

Les figures 3 à 9 sont des coupes schématiques simplifiées d'un substrat, illustrant des étapes successives de fabrication d'un dispositif à capacité variable, conformément au procédé de l'invention.

Les figures 10 et 11 sont des coupes schématiques de substrats différents de celui de la figure 3 également utilisables pour la réalisation d'un dispositif conforme à l'invention.

Les figures 12 et 13 sont des coupes schématiques simplifiées d'un substrat, illustrant des étapes de fabrication d'un dispositif à capacité variable, conformément au procédé de l'invention, et constituant une variante par rapport aux étapes des figures 7 à 9.

La figure 14 est une coupe schématique et simplifiée d'un dispositif à capacité variable conforme à l'invention, obtenu conformément au procédé illustré par les figures 12 et 13.

### Description détaillée de modes de mise en oeuvre de l'invention.

Dans la description qui suit des parties identiques, similaires ou équivalentes des différentes figures sont repérées par les mêmes signes de référence pour faciliter le report entre les figures. Par ailleurs, et dans un souci de clarté des figures, tous les éléments ne sont pas représentés selon une échelle uniforme.

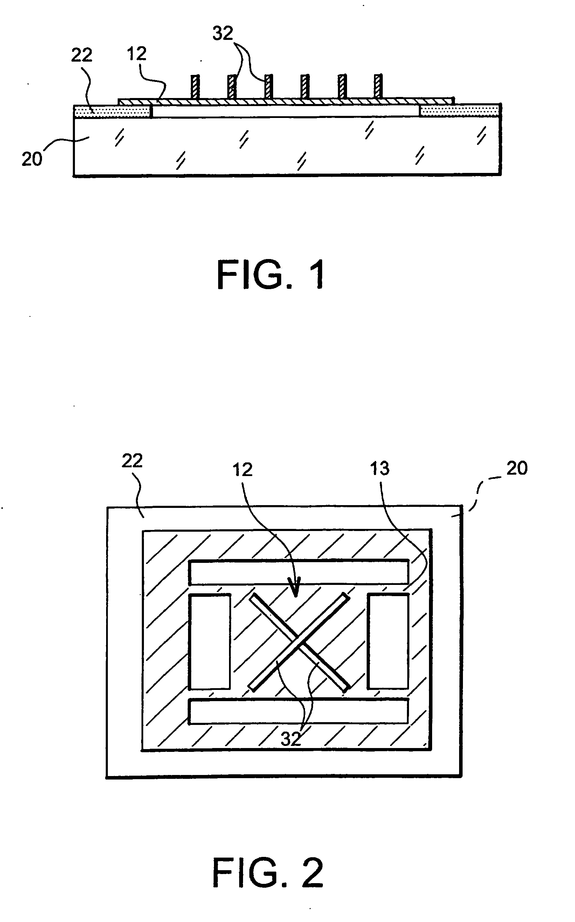

La figure 1, montre un dispositif à capacité variable conforme à l'invention.

Celui-ci comporte une membrane 12 en un matériau conducteur électrique. Celle-ci est maintenue séparée, mais en regard, d'un support 20, par une couche de séparation 22 en un matériau diélectrique. Le support 20 est également en un matériau conducteur électrique. Il forme avec la membrane les armatures d'un condensateur de capacité variable. La capacité peut être modifiée en exerçant sur la membrane une pression sous l'effet de laquelle elle se déforme légèrement, pour se rapprocher ou se séparer davantage du support.

La membrane est pourvue, sur sa face opposée au substrat, d'une pluralité de lamelles qui forment autant de nervures de rigidité 32. Les lamelles peuvent être rapportées sur la membrane ou être réalisées d'une seule pièce avec celle-ci.

Les lamelles 32 permettent d'augmenter la rigidité de la membrane et donc de réduire son épaisseur à des valeurs très faibles. L'épaisseur de la membrane peut être inférieure à celle qui serait nécessaire pour qu'elle soit autoporteuse en l'absence de nervures.

La figure 2 est une vue de dessus d'un autre dispositif à capacité variable conforme à l'invention. Sur cette figure, la membrane 12 constitue également une armature mobile d'un condensateur. La mobilité de l'armature ne résulte pas de la flexibilité de la membrane mais de celle de poutrelles 13 qui suspendent la membrane en la reliant au support 20.

La membrane 12 est pourvue d'une nervure 32 en croix qui s'étend selon les diagonales de l'une de ses faces principales. La face principale opposée est tournée vers une partie du substrat non visible qui forme l'armature fixe.

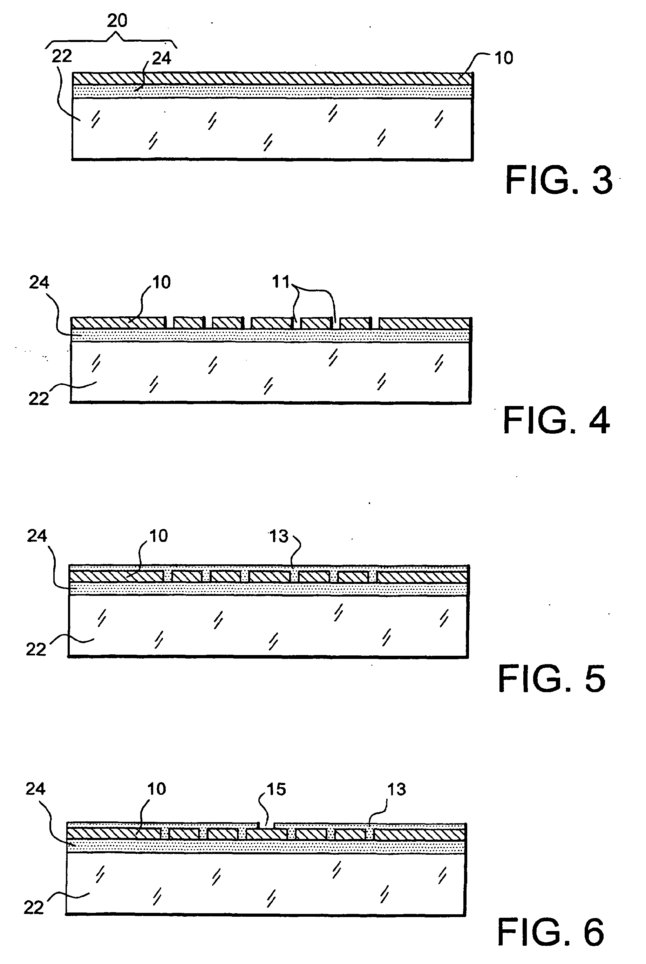

La figure 3 montre un substrat utilisable pour la réalisation d'un dispositif conforme à l'invention. Le substrat 20 comprend une partie massive 22 en silicium et une couche mince 10 superficielle en silicium, de préférence monocristallin.

La couche mince 10 est reliée à la partie massive 22 par l'intermédiaire d'une couche enterrée isolante 24. Il s'agit, dans l'exemple illustré, d'une couche d'oxyde de silicium.

Un substrat tel que représenté à la figure 3 est en soi connu. Il s'agit par exemple d'un substrat de type SOI (Silicon On Insulator, silicium sur isolant). De tels substrats sont usuellement formés par report d'une couche mince de silicium sur une plaquette de silicium préalablement oxydé.

Il convient de préciser que d'autres substrats présentant une couche superficielle conductrice, ou recouverte d'un film conducteur, et isolée de la partie massive, peuvent également être retenus. On peut utiliser, par exemple, une couche de cuivre ou d'aluminium pour la couche mince et des couches diélectriques, en polymère ou en verre (PSG), pour former la couche enterrée. La partie massive du substrat peut selon les réalisations être semiconductrice isolante ou même conductrice.

La figure 4 montre la réalisation d'ouvertures 11 dans la couche mince superficielle 10. Les ouvertures sont pratiquées dans une partie centrale de la couche mince superficielle dans laquelle une membrane du dispositif doit être ultérieurement formée. La partie centrale est bordée d'une région où la couche mince superficielle 10 est dépourvue d'ouvertures.

Les ouvertures 11 peuvent être formées par gravure sélective du silicium, avec arrêt sur l'oxyde de silicium sous-jacent, selon un motif dicté par un masque. Le masque n'est pas représenté.

La figure 5 montre le dépôt d'une nouvelle couche intercalaire 13 d'oxyde de silicium qui recouvre la couche mince superficielle 10 et qui comble les ouvertures 11 préalablement réalisées. La couche intercalaire 13 peut être remplacée par une autre couche en un matériau isolant et susceptible d'être gravé sélectivement par rapport au matériau de la couche mince superficielle.

La figure 6 montre la réalisation d'une ouverture d'accrochage 15 dans la couche intercalaire 13, de façon à mettre à nu une zone de la couche mince superficielle 10. On prend soin ici de ne pas faire coïncider l'ouverture d'accrochage avec une ouverture préalablement pratiquée dans la couche superficielle sous-jacente. Comme cela apparaît dans la suite de la description, l'ouverture d'accrochage 15 a pour but de permettre la fixation d'une nervure de rigidité sur la membrane. Plusieurs ouvertures d'accrochages peuvent être prévues. Elles sont ménagées essentiellement dans une partie centrale où une membrane doit être ultérieurement libérée.

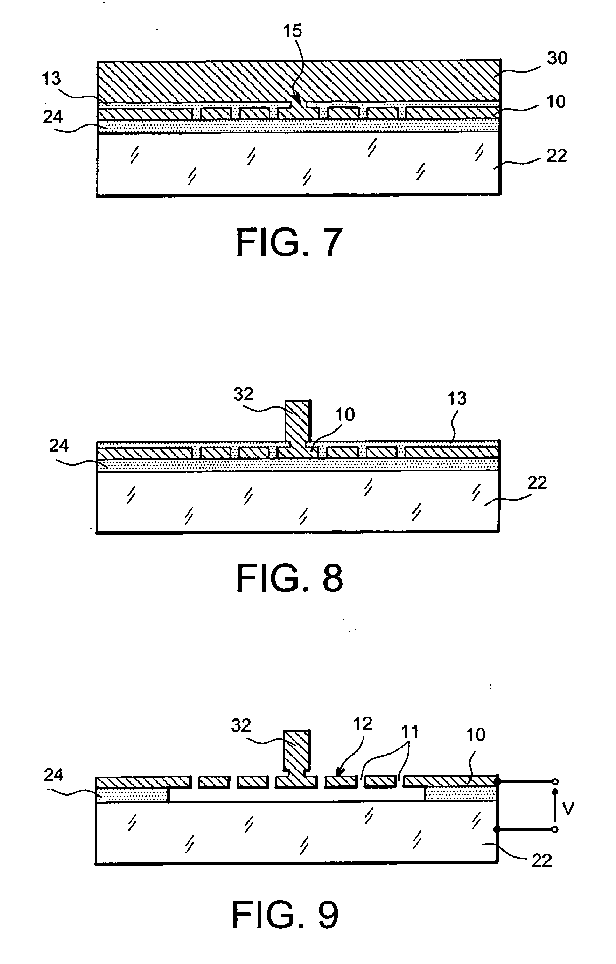

La figure 7 montre le dépôt d'une couche épaisse de silicium polycristallin 30. L'épaisseur de cette couche peut être choisie supérieure à celle de la couche mince 10, elle fixe l'épaisseur d'une nervure formée ultérieurement. La couche épaisse 30, encore désignée par « couche de rigidité », vient recouvrir la couche intercalaire 13 et se fixer sur la couche mince superficielle 10 dans l'ouverture d'accrochage 15.

Une gravure sélective de la couche de rigidité 30 permet d'y dégager une nervure 32 visible à la figure 8 La nervure est solidaire de la couche mince superficielle à travers l'ouverture d'accrochage et peut s'étendre en partie au-dessus de la couche intercalaire 13. La gravure de la couche épaisse 30, sélective par rapport à l'oxyde de silicium, fait appel à un masque de gravure non représenté. Celui-ci fixe les dimensions et l'emplacement de la nervure 32.

Une dernière gravure isotrope et sélective de l'oxyde de silicium par rapport au silicium de la couche mince superficielle 10 et de la nervure 32 permet d'éliminer la couche intercalaire 13. La même gravure permet aussi d'attaquer la couche enterrée 22 sous-jacente. Cette attaque est possible grâce aux ouvertures 11 préalablement pratiquées dans la couche mince superficielle. Le caractère isotrope de la gravure permet d'éliminer l'oxyde de silicium aussi dans des régions entourant les ouvertures 11, jusqu'à libérer une partie de la couche mince superficielle 10 pour former une membrane 12.

La membrane 12, rendue libre par l'élimination partielle de la couche d'oxyde sous-jacente, est susceptible d'être déformée et constitue une armature mobile. La partie massive du substrat semi-conducteur 22 constitue une armature fixe en regard de la membrane.

Dans la région périphérique entourant la membrane, l'absence d'ouvertures dans la couche mince superficielle fait que celle-ci protège localement la couche d'oxyde sous-jacente lors de la gravure. Le reliquat de la couche d'oxyde isolante 24 permet de suspendre la membrane et de la relier à la partie massive du substrat. Le lien formé par le reliquat de la couche d'oxyde est un lien mécanique et non un lien électrique. Il convient de préciser que les ouvertures 11 dans la couche mince superficielle pourraient éventuellement être remplacées par un autre type de canal d'accès, par exemple à travers la partie massive 22, pour autoriser une gravure de libération de la membrane.

La description qui précède illustre une possibilité très rudimentaire de mise en oeuvre de l'invention dans laquelle le substrat, dans son ensemble, ou plus précisément sa partie massive 22 dans son ensemble, constitue une armature du condensateur de capacité variable.

Une telle réalisation du dispositif risque éventuellement d'induire des difficultés d'isolation électrique lorsque d'autres composant doivent être formés dans le même substrat. Une possibilité pour rendre au substrat sa fonction de support exclusivement mécanique consiste à réaliser sur celui-ci une armature fixe, électriquement isolée.

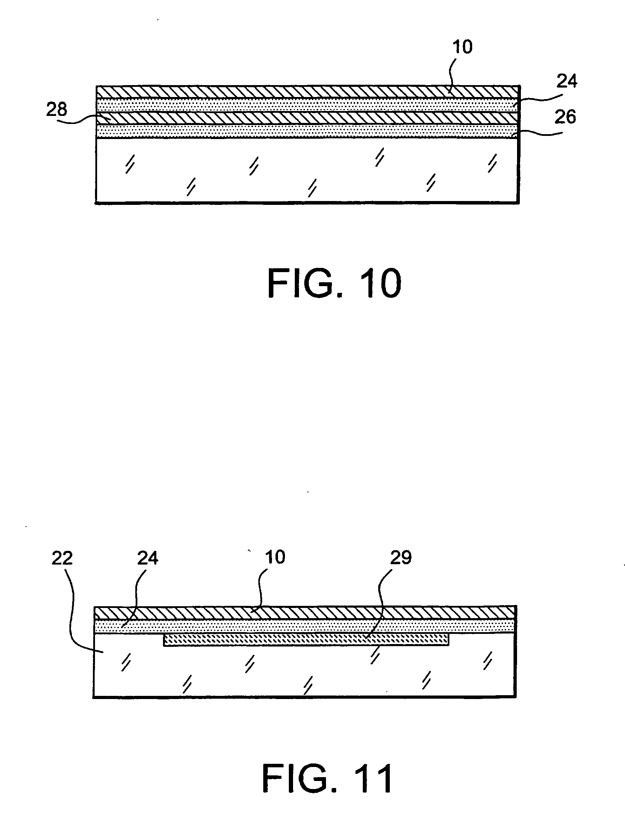

La figure 10 montre un substrat utilisable à cet effet. Le substrat de la figure 10 comprend une partie massive 22, une première couche enterrée d'oxyde 24, et une couche mince superficielle de silicium 10. Ces parties sont les mêmes que celles de la figure 3. Le substrat de la figure 10 comporte en outre une deuxième couche d'oxyde de silicium 26 et une couche mince de silicium 28 enterrées et disposées dans cet ordre entre la partie massive et la première couche enterrée 24. La deuxième couche d'oxyde de silicium 26 isole électriquement la couche mince enterrée de la partie massive du substrat. Un tel substrat peut être obtenu aisément à partir d'un substrat SOI, en y ajoutant une couche d'oxyde puis une couche mince de silicium. La deuxième couche mince de silicium peut, par exemple, y être reportée.

Un dispositif à capacité variable peut être réalisé à partir de ce substrat selon le procédé précédemment décrit. La couche enterrée de silicium 28 joue alors le rôle de couche d'arrêt de gravure lors de l'attaque de l'oxyde de silicium de la première couche enterrée d'oxyde lors de la libération de la membrane. Dans le dispositif finalement obtenu, la couche enterrée de silicium 28 joue alors le rôle d'armature fixe.

La figure 11 montre encore un autre type de substrat susceptible d'être retenu. Il s'agit d'un substrat conforme à la figure 3, avec une couche mince superficielle 10 en silicium monocristallin ou polycristallin, par exemple, de type SOI.

Une zone dopée 29 est formée par implantation dans la partie massive du substrat, sous la couche enterrée. Les impuretés dopantes mises en oeuvre sont d'un type de conductivité opposé à celui de la partie massive. Le dispositif à capacité variable est ensuite poursuivi de la façon déjà décrite.

La zone dopée 29 est utilisée comme armature fixe et forme une diode avec le reste de la partie massive. Elle est polarisée dans un sens bloquant pour contrarier toute fuite de courant.

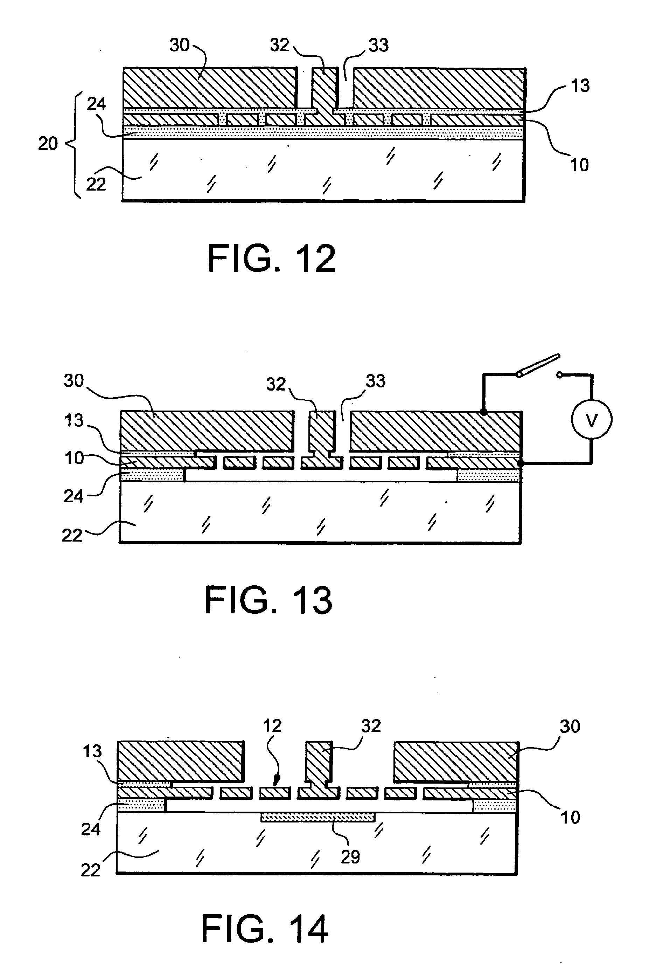

La figure 12 illustre une étape d'une variante du procédé, qui prend place après l'étape décrite en référence à la figure 7.

La couche épaisse de silicium 30 est gravée selon un masque pour y pratiquer des tranchées 33. Les tranchées 33 traversent la couche épaisse de silicium et y délimitent la ou les nervures de rigidité 32. La partie restante de la couche épaisse 30 est toutefois préservée.

La figure 13 montre la structure obtenue après une attaque de l'oxyde de silicium de la couche d'oxyde enterrée 24 et de la couche intercalaire 13 à travers les tranchées 33. Cette attaque, sélective par rapport au silicium, permet de libérer la membrane 12 par rapport à la partie massive 22 du substrat 20 mais aussi par rapport à la couche épaisse de silicium 30. En effet la gravure chimique anisotrope permet d'éliminer aussi de façon locale la couche intercalaire 13 dans la région de la membrane. Le reliquat de la couche intercalaire 13 permet de maintenir la couche de rigidité épaisse 30 à distance de la membrane et de l'en isoler électriquement.

On obtient une double capacité variable. Une première capacité variable est formée entre la partie massive du substrat et la membrane, et la deuxième capacité variable, entre la membrane et la partie restante de couche de rigidité 30. Cette dernière, lorsqu'elle est suffisamment épaisse pour ne pas être déformée, constitue en effet une armature fixe. Un mouvement de la membrane provoque une modification en sens inverse de ces deux capacités.

Pour réaliser des moyens de commande de la capacité variable, il est possible d'utiliser l'une des armatures fixes et d'y appliquer une tension électrostatique de déplacement ou de déflexion de la membrane. Ceci est indiqué par la représentation symbolique d'un générateur de tension connecté entre la membrane et la partie restante de la couche épaisse. La partie restante de la couche de rigidité constitue alors une électrode de commande et la partie massive du substrat, une électrode de signal.

La figure 14 montre un dispositif conforme au dispositif de la figure 13 obtenu avec un substrat conforme au substrat de la figure 11. Il comprend une électrode 29, implantée dans le substrat et formant une armature fixe. Un masquage de l'implantation permet de d'implanter l'électrode 29 dans une région de la membrane qui ne soit pas en regard de l'autre armature fixe formée par la partie restante de la couche de rigidité 30. Un dispositif conforme à la figure 14 permet de réduire d'éventuelles influences entre l'armature fixe formée par l'électrode 29 et celle formée par la partie restante de la couche de rigidité 30.

Bien que la description qui précède se borne à illustrer des exemples de réalisation simples, il convient de préciser que le dispositif de l'invention peut être réalisé avec des formes différentes des armatures. De plus, le procédé de fabrication peut avantageusement être mis en oeuvre pour la formation collective d'un grand nombre de dispositifs à capacité variable, identiques ou non, dans un même substrat.

### DOCUMENTS CITES

***(1)***
TOPICAL REVIEW - « RF MENS from a device perspective De J. JASON Yao J. Micromech. Microeng. 10 (2000) R9-R38
***(2)***
US-A-4 653 326 (3***)***
US-A-5 495 761 (4***)***
US-A-5 576 250

## Revendications

1. Dispositif à capacité variable intégrée comprenant au moins une membrane (12), formant au moins une armature mobile, et présentant au moins une face principale en regard d'au moins une armature fixe (22, 30), **caractérisé en ce que** la membrane est solidaire d'au moins une nervure de rigidité (32) se dressant dans une direction perpendiculaire à ladite face principale.

2. Dispositif selon la revendication 1, comprenant un substrat (22) de support de la membrane, le substrat formant au moins une armature fixe.

3. Dispositif selon la revendication 2, dans lequel le substrat présente une couche (28, 29) électriquement conductrice formant l'armature fixe.

4. Dispositif selon la revendication 1, dans lequel le substrat comporte une première partie (22, 29) disposée en regard d'une première face principale de la membrane (12) et une deuxième partie (30), solidaire de la première partie, et disposée en regard d'une deuxième face principale de la membrane, au moins l'une des première et deuxième parties formant une armature fixe.

5. Dispositif selon la revendication 4, dans lequel la deuxième partie (30) est une couche électriquement conductrice rigide.

6. Procédé de fabrication d'au moins un dispositif à capacité variable dans lequel :
a) on fournit un substrat (20) présentant au moins une première couche d'armature mince (10) reliée à une partie massive (22) par une couche enterrée (24),
b) on forme sur la première couche d'armature mince, une couche d'arrêt de gravure (13), la couche d'arrêt de gravure présentant au moins une ouverture d'accrochage (15) débouchant sur une partie de la couche d'armature mince (10) destinée à former une armature mobile,
c) on forme au moins une couche de rigidité (30) recouvrant la couche d'arrêt de gravure, et venant en contact avec la première couche d'armature mince (10) dans l'ouverture d'accrochage (15),
d) on pratique une gravure sélective de la couche de rigidité (30) pour y définir au moins une nervure (32) s'étendant au-dessus de l'ouverture d'accrochage, et sur la partie de la couche d'armature mince destinée à former une armature mobile,
e) on libère ladite partie par élimination locale de la couche d'arrêt de gravure (13) et de la couche enterrée (24), pour former une armature mobile (12).

7. Procédé selon la revendication 6, dans lequel on utilise une couche d'arrêt de gravure (13) en un matériau isolant électrique et une couche de rigidité (30) en un matériau électriquement conducteur et on préserve, lors de l'étape d), une partie de la couche de rigidité (30) s'étendant au-dessus de la partie de la couche d'armature mince (10) destinée à former une armature mobile, et on libère mutuellement lesdites parties de la couche de rigidité et de la couche d'armature mince.

8. Procédé selon la revendication 6, dans lequel on fournit un substrat présentant en outre, sous la première couche d'armature (10), une deuxième couche d'armature enterrée (28), électriquement isolée de la première couche d'armature, et on préserve au moins une partie de cette couche en regard de l'armature mobile (12), pour former une armature fixe.

9. Procédé selon la revendication 6, dans lequel on forme dans la partie massive (22) du substrat une zone conductrice (29), formant armature fixe, par implantation ionique.

10. Procédé selon la revendication 6, dans lequel, avant l'étape b), on pratique dans la première couche mince d'armature au moins une ouverture de gravure (11) pour l'élimination ultérieure sélective de la couche enterrée sous-jacente.

## Claims

1. Integrated variable capacitance device comprising at least one membrane (12), forming at least one mobile armature, and having at least one principal face facing at least one fixed armature (22, 30), **characterised in that** the membrane is integral with at least one rigidity rib (32) lying in a perpendicular direction to said principal face.

2. Device according to claim 1, comprising a substrate (22) for supporting the membrane, the substrate forming at least one fixed armature.

3. Device according to claim 2, in which the substrate has an electrically conductive layer (28, 29) forming the fixed armature.

4. Device according to claim 1, in which the substrate comprises a first part (22, 29) arranged facing a first principal face of the membrane (12) and a second part (30), integral with the first part, and arranged facing a second principal face of the membrane, at least one of the first and second parts forming a fixed armature.

5. Device according to claim 4, in which the second part (30) is a rigid electrically conductive layer.

6. Method for producing at least one variable capacitance device in which:
a) One provides a substrate (20) having at least one first thin armature layer (10) linked to a solid part (22) by a buried layer (24).
b) One forms on the first thin armature layer an etching barrier layer (13), said etching barrier layer having at least one coupling opening (15) leading into a part of the thin armature layer (10) intended to form a mobile armature.
c) One forms at least one rigidity layer (30) covering the etching barrier layer, and coming into contact with the first thin armature layer (10) in the coupling opening (15).
d) One carries out a selective etching of the rigidity layer (30) in order to form on it at least one rib (32) extending out above the coupling opening, and on the part of the thin armature layer intended to form a mobile armature.
e) One liberates said part by local elimination of the etching barrier layer (13) and the buried layer (24), in order to form a mobile armature (12).

7. Method according to claim 6, in which one uses an etching barrier layer (13) in an electrically insulating material and a rigidity layer (30) in an electrically conductive material and one preserves, during step d), a part of the rigidity layer (30) extending above the part of the thin armature layer (10) intended to form a mobile armature, and one mutually liberates said parts of the rigidity layer and the thin armature layer.

8. Method according to claim 6, in which one provides a substrate having, moreover, under the first armature layer (10), a second buried armature layer (28), electrically insulated from said first armature layer, and one preserves at least one part of this layer facing the mobile armature (12), in order to form a fixed armature.

9. Method according to claim 6, in which one forms in the solid part (22) of the substrate a conductive zone (29), forming the fixed armature, by ion implantation.

10. Method according to claim 6, in which, before step b), one forms in the first thin armature layer at least one etching opening (11) for subsequently selectively eliminating the underlying buried layer.

## Patentansprüche

1. Integriertes Bauelement von variabler Kapazität mit mindestens einer einen beweglichen Belag bildenden Membran (12) und wenigstens einer mindestens einem festen Belag (22, 30) gegenüberstehenden Hauptseite
**dadurch gekennzeichnet, dass** die Membran fest verbunden ist mit mindestens einer Versteifungsrippe (32), die in einer zu der genannten Hauptseite senkrechten Richtung emporragt.

2. Bauelement nach Anspruch 1 mit einem Membranträgersubstrat (22), wobei das Substrat wenigstens einen festen Belag bildet.

3. Bauelement nach Anspruch 2, bei dem das Substrat eine einen elektrisch leitfähigen festen Belag bildende Schicht (28, 29) aufweist.

4. Bauelement nach Anspruch 1, bei dem das Substrat einen ersten Teil (22, 29) umfasst, der einer ersten Hauptseite der Membran (12) gegenüberstehend angeordnet ist, und einen zweiten Teil (30), der fest mit dem ersten Teil verbunden ist und einer zweiten Hauptseite der Membran gegenüberstehend angeordnet ist, wobei wenigstens einer der beiden Teile, entweder der erste oder der zweite, einen festen Belag bildet.

5. Bauelement nach Anspruch 4, bei dem der zweite Teil (30) eine starre elektrisch leitfähige Schicht ist.

6. Verfahren zur Herstellung wenigstens eines Bauelements von variabler Kapazität wie folgt:
a) man realisiert ein Substrat (20) mit mindestens einer dünnen ersten Belagschicht (10), verbunden mit einem massiven Teil (22) durch eine vergrabene Schicht (24),
b) man bildet auf der dünnen ersten Belagschicht eine Ätzsperrschicht (13), wobei die Ätzsperrschicht (13) mindestens eine Befestigungsöffnung (15) aufweist, die in dem Teil der dünnen Belagschicht (10) mündet, der dazu bestimmt ist, einen beweglichen Belag zu bilden,
c) man erzeugt wenigstens eine die Ätzsperrschicht bedeckende Versteifungsschicht (30), wobei man in der Befestigungsöffnung (15) einen Kontakt bzw. eine Bindung mit der dünnen ersten Schicht (10) herstellt,
d) man praktiziert eine selektive Ätzung der steifen Schicht (30) und realisiert dabei mindestens eine Versteifungsrippe (32), die sich über der Befestigungsöffnung und in dem Teil der dünnen Belagschicht ausdehnt, der dazu bestimmt ist, einen beweglichen Belag zu bilden,
e) man befreit den genannten Teil durch lokale Eliminierung der Ätzsperrschicht (13) und der vergrabenen Schicht (24), um den Belag (12) beweglich zu machen.

7. Verfahren nach Anspruch 6, in dem man eine Ätzsperrschicht (13) aus einem elektrisch isolierenden Material und eine Versteifungsschicht (30) aus einem elektrisch leitfähigen Material benutzt und während des Schritts d) einen Teil der Versteifungsschicht (30) bestehen lässt, der sich über der dünnen Belagschicht (10) erstreckt, die dazu bestimmt ist, einen beweglichen Belag zu bilden, und man die genannten Teile der Versteifungsschicht und der dünnen Belagschicht wechselseitig frei macht.

8. Verfahren nach Anspruch 6, in dem man ein Substrat realisiert, das außerdem unter der ersten Belagschicht (10) eine vergrabene, von der ersten Belagschicht elektrisch isolierte zweite Belagschicht (28) umfasst, und man wenigstens einen dem beweglichen Belag (12) gegenüberstehenden Teil dieser Schicht bestehen lässt, um einen festen Belag zu bilden.

9. Verfahren nach Anspruch 6, in dem man in dem massiven Teil (22) des Substrats durch Ionenimplantation eine leitfähige Zone (29) realisiert, die einen festen Belag bildet.

10. Verfahren nach Anspruch 6, in dem man vor dem Schritt b) in der dünnen ersten Schicht mindestens eine Ätzöffnung (11) schafft, zur späteren selektiven Eliminierung der darunterliegenden vergrabenen Schicht.
